# FASCICULE DE BREVET EUROPEEN

(11) **EP 2 277 231 B1**
(45) Date de publication et mention de la délivrance du brevet: **08.02.2012**
(21) Numéro de dépôt: 09734594.6
(22) Date de dépôt: 21.04.2009
(51) Int. Cl.: H01M 14/00, H01G 9/00, H01L 31/00

(54) **PROCÉDÉ ET DISPOSITIF DE PRODUCTION ET DE STOCKAGE D'ÉNERGIE ÉLECTRIQUE**
VERFAHREN UND VORRICHTUNG ZUR PRODUKTION UND SPEICHERUNG VON ENERGIE
METHOD AND DEVICE FOR PRODUCING AND STORING ENERGY

(30) Priorité: 21.04.2008 US 124923
(43) Date de publication de la demande: 26.01.2011
(73) Titulaire: I.S.2 Société par Actions Simplifiée (SAS), 57400 Sarrebourg (FR)
(72) Inventeur: WELTER, Richard, F-67400 Illkirch-Graffenstaden (FR)
(74) Mandataire: Nithardt, Roland
(86) Numéro de dépôt international: PCT/IB2009/005303
(87) Numéro de publication internationale: WO 2009/130562

(56) Documents cités:
- JP-A- 2000 012 882
- JP-A- 2007 277 513
- BEGHIDJA ET AL: "Une etude structurale de ligands derivant de l'acide 2-hydroxy hydrazide benzoique : utilisation pour l'elaboration de nouveaux complexes moleculaires magnetiques" COMPTES RENDUS - CHIMIE, ELSEVIER, PARIS, FR, vol. 10, no. 7, 13 juillet 2007 (2007-07-13), pages 590-597, XP022153758 ISSN: 1631-0748
- JOZEF SIMA, MARIO IZAKOVIC, MARIAN ZITNANSKY: "Mechanism of Deactivation Processes of Excited Iron(III) Thiocyanato Complexes with Benacen-Type Ligands" INTERNATIONAL JOURNAL OF PHOTOENERGY, vol. 2006, 2006, pages 1-5, XP002540040 DOI: 10.1155/IJP/2006/78234
- APURBA K. PATRA, MARILYN M. OLMSTEAD, AND PRADIP K. MASCHARAK: "Spontaneous Reduction of a Low-Spin Fe(III) Complex of a Neutral Pentadentate N5 Schiff Base Ligand to the Corresponding Fe(II) Species in Acetonitrile" INORGANIC CHEMISTRY, vol. 41, no. 21, 6 septembre 2002 (2002-09-06), pages 5403-5409, XP002540041 DOI: 10.1021/ic020373w

## Description

### Domaine technique:

La présente invention concerne un procédé de production et de stockage d'énergie électrique utilisant des complexes d'un métal.

Elle concerne également un dispositif pour la mise en oeuvre de ce procédé de production et de stockage d'énergie électrique.

### Technique antérieure :

La littérature scientifique fournit quelques exemples de réduction photo-induite. On peut en particulier citer les articles suivants : - D.A.S. Finden, E. Tipping, G.H.M. Jaworski and C.S. Reynolds, Nature, Vol.309, 28 june 1984 - ; - G.K. Oster, G. Oster, J. Am. Chem. Soc. 1959, 81, 5543; E.L. Wehry, R. A. Ward, Inorg. Chem., 1971, 10, 12, 2660 - ; - B.C. Faust and R. G. Zepp, Environ. Sci. Technol. 1993, 27, 2517 - ; - J. Sima and J. Makanova, Coordination Chemistry Reviews, 160, 1997, 161 - ;- L. Emmenegger, R. Schonenberger, L. Sigg and B. Sulzberger, Limnol. Oceanogr., 46(1), 2001, 49 -; et - J. Sima, L. Horvathova, M. Izakovic, Monat. Chem., 2004, 135, 5 -.

Par ailleurs, la publication Beghida et Al., Comptes Rendus - Chimie, Elsevier, Paris, Vol.10, N°7, 13 juillet 2007, nous enseigne la possibilité d'utiliser des ligands dérivant de l'acide 2-hydroxy hydrazide benzoïque pour l'élaboration de nouveaux complexes moléculaires magnétiques.

En outre, la publication J.Sima, M.Izakovic, M.Zitnanski, International Journal of Photoenergy, Vol. 2006, 2006, pages 1 à 5, décrit le mécanisme du procédé de désactivation de complexes de fer^{III} formé avec des ligands de type Benacen.

Toutefois, aucun des systèmes décrits ne présente une stabilité suffisante lui permettant une utilisation à la fois en solution et/ou à l'état solide.

### Exposé de l'invention :

La présente invention se propose d'ouvrir une voie nouvelle dans l'élaboration de dispositifs physico-chimiques simples et économiques pour produire de l'énergie électrique en utilisant la lumière naturelle. En outre, la présente invention répond intégralement aux critères de reconversion et/ou de transformation imposés en matière de préservation de l'environnement et d'absence de nuisance pour la biosphère.

Ce but est atteint par le procédé de l'invention, tel que défini en préambule, caractérisé en ce que l'on utilise un complexe moléculaire de fer dérivant de l'acide benzoïque, ce complexe comportant au moins un ligand organique de type benzoïque hydrazide, et l'on crée des réactions d'oxydoréduction dans ledit complexe moléculaire de fer en l'exposant à la lumière, à l'abri de l'air, et réciproquement à l'air, à l'abri de la lumière.

D'une manière particulièrement avantageuse, ledit ligand organique est choisi parmi la famille de ligands définis par la formule :

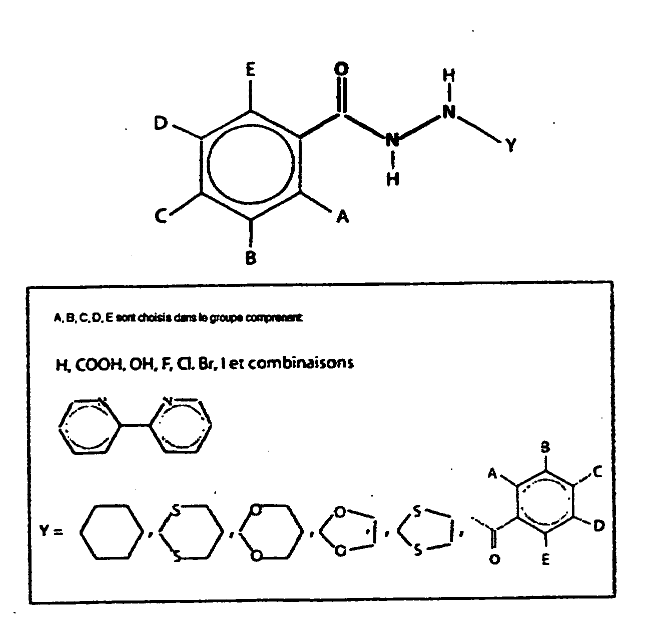

Ledit complexe de fer est de préférence soit : le complexe de fer (Fe ³⁺) défini par la formule [Fe^{III}(HL)ₓCl, Solvant], soit le complexe de fer (Fe ²⁺) défini par la formule [Fe^{II}(H₂L)₂Cl₂]. HL et H₂L représentent les deux états chimiques d'un ligand organique tel que précédemment défini, selon qu'il est complexé soit au fer oxydé soit au fer réduit. Ainsi, H₂L correspond à un état dans lequel un atome d'hydrogène est présent sur l'atome d'azote central, tandis que HL concerne un état dans lequel l'atome d'hydrogène est absent sur ce même atome d'azote

Selon un mode de réalisation, l'on produit une réduction du fer (Fe ³⁺) dans ledit complexe [Fe^{III}(HL)ₓCl, Solvant] en fer (Fe ²⁺) dans ledit complexe [Fe^{II}(H₂L)₂Cl₂] en l'exposant à la lumière à l'abri de l'oxygène.

Selon un autre mode de réalisation, l'on produit une oxydation du fer (Fe ²⁺) dans ledit complexe [Fe^{II}(H₂L)₂Cl₂] en fer (Fe ³⁺) dans ledit complexe [Fe^{III}(HL)ₓCl, Solvant] en créant un contact chimique ou électrochimique avec un oxydant, à l'abri de la lumière.

De façon avantageuse, ledit oxydant peut être choisi dans le groupe : O₂, I₂, Cu²⁺, Co³⁺, FeCl₃, H⁺, manganate et permanganate, ferrates.

De façon avantageuse, l'on peut choisir ledit solvant parmi les solvants suivants : le diméthylformamide (DMF), le tétrahydrofurane (THF), l'éthanol, l'eau.

Il est également atteint par le dispositif de l'invention tel que défini en préambule, caractérisé en ce qu'il comprend un complexe moléculaire de fer comportant au moins un ligand organique de type acide benzoïque hydrazide.

Ledit ligand organique est avantageusement choisi parmi la famille de ligands définis par la formule ci-dessous :

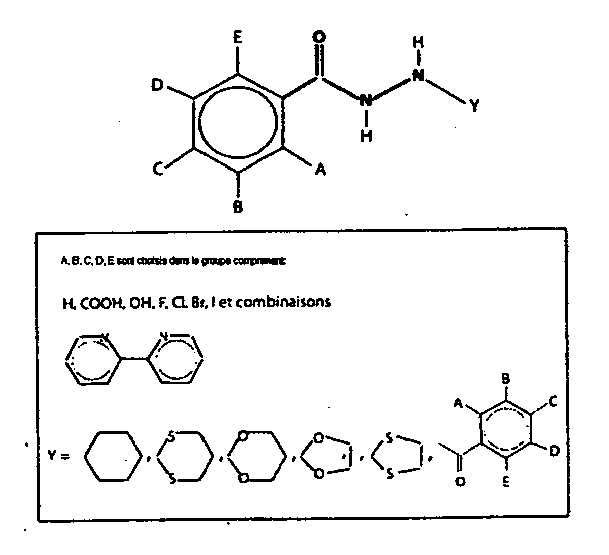

Selon une forme de réalisation particulièrement avantageuse, ledit complexe de fer est soit : le complexe de fer (Fe ³⁺) défini par la formule [Fe^{III}(HL)ₓCl, Solvant], soit le complexe de fer (Fe ²⁺) défini par la formule [Fe^{II}(H₂L)₂Cl₂]. HL et H₂L représentent les deux états chimiques d'un ligand organique tel que précédemment défini, selon qu'il est complexé soit au fer oxydé soit au fer réduit. Ainsi, H₂L correspond à un état dans lequel un atome d'hydrogène est présent sur l'atome d'azote central, tandis que HL concerne un état dans lequel l'atome d'hydrogène est absent sur ce même atome d'azote

Selon une forme de réalisation, le dispositif comporte avantageusement des moyens pour produire une réduction du fer (Fe ³⁺) dans ledit complexe [Fe^{III}(HL)ₓCl, Solvant] en fer (Fe ²⁺) dans ledit complexe [Fe^{II}(H₂L)₂Cl₂] ces moyens impliquant une exposition à la lumière à l'abri d'un oxydant, dudit complexe de fer (Fe ³⁺).

Selon une autre forme de réalisation, le dispositif comporte avantageusement des moyens pour produire une oxydation du fer (Fe ²⁺) dans ledit complexe [Fe^{II}(H₂L)₂Cl₂) en fer (Fe ³⁺) dans ledit complexe [Fe^{III}(HL)₂Cl, Solvant] ces moyens impliquant une action d'un oxydant adapté, à l'abri de la lumière sur ledit complexe de fer (Fe ²⁺).

### Description sommaire des figures et schémas :

La présente invention et ses avantages apparaîtront mieux dans la description suivante de plusieurs modes de réalisation, donnés à titre d'exemples non limitatifs en référence aux dessins annexés, dans lesquels :
- la figure 1 est une vue schématique représentant la transformation du complexe de fer (Fe ²⁺) en complexe de fer (Fe ³⁺) et réciproquement,
- la figure 2 est une vue représentant une molécule du complexe de fer (Fe³⁺),
- la figure 3 est une vue représentant une molécule du complexe de fer (Fe ²⁺),
- la figure 4 représente un cyclovoltammogramme du complexe de fer (Fe³⁺),
- la figure 5 représente les courbes intensité/potentiel mesurées sur électrode quasi stationnaire en carbone vitreux pour le complexe de fer (Fe ³⁺) et le complexe de fer (Fe ²⁺), et
- la figure 6 représente schématiquement le processus de réduction spontanée à la lumière naturelle selon l'invention.

### Différentes manières de réaliser l'invention :

On sait, par diverses publications, que les ligands organiques de type acide benzoïque hydrazide complexent de nombreux métaux de transition tels le fer, le manganèse, notamment à leur degrés d'oxydation habituels, (2+) ou (3+). Ces ligands dérivant de l'acide benzoïque ont été déjà synthétisés, purifiés et caractérisés en laboratoire, par les différentes méthodes spectroscopiques et de diffraction des rayons X.

A titre d'exemple non limitatif, une sélection de ce type de ligands est donnée par les formules ci-dessous :

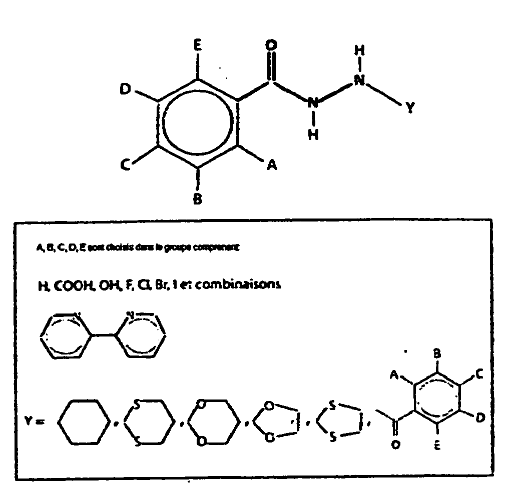

Des essais de complexation effectués en laboratoire avec différents sels de manganèse (Mn ²⁺), (Mn ³⁺), de chrome (Cr ³⁺), de cuivre et de fer (Fe ³⁺), ont conduit à de nouveaux complexes mononucléaires, de structures originales. Des essais ont en particulier été effectués avec le fer et ont permis de constater que dans un complexe [Fe^{III}(HL)₂Cl, Solvant] désigné par C₁, une réduction du fer (Fe ³⁺) s'effectuait dans certaines conditions pour donner un nouveau complexe de fer (Fe²⁺) [Fe^{II}(H₂L)₂Cl₂] désigné par C₂ et réciproquement, en modifiant les conditions.

Le complexe C₁ peut être obtenu à l'état solide à partir d'une diffusion lente de diethyléther dans le solvant qui est le diméthylformamide (DMF). La réaction se fait à l'air et à l'abri de la lumière. Cette réaction est matérialisée par la formation de monocristaux bleu nuit du complexe C₁.

Une exposition du mélange à l'abri de l'air et à la lumière, c'est-à-dire dans les conditions inverses de celles qui ont permis de former le complexe C₁ conduit à la formation d'une solution jaune puis à une cristallisation sous la forme de cristaux jaunes du complexe C₂. Ces cristaux jaunes, obtenus après lente diffusion de diethyléther dans la solution de DMF, sont sensibles à l'air. En effet, en présence d'oxygène de l'air, ils changent de couleur et se transforment en un solide bleu. En outre, la solubilisation des monocristaux jaunes correspondant au complexe C₂ dans la solution de DMF en présence d'air donne instantanément une solution bleue correspondant au complexe C₁. Le passage d'un des complexes à l'autre est réversible.

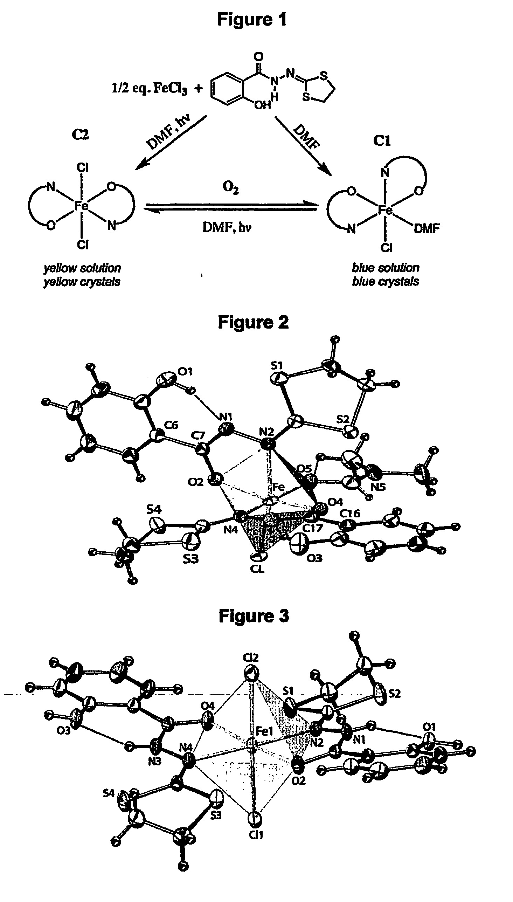

La figure 1 représente schématiquement cette transformation. La réaction de base s'effectue entre un ligand H₂L et du chlorure de fer FeCl₃ en présence du solvant DMF. L'on produit les complexes C₁ et C₂. Le complexe C₁ exposé à la lumière, mais à l'abri de l'air, se transforme par photo réduction en complexe C₂. A l'abri de lumière, mais exposé à l'air, plus précisément à l'oxygène de l'air, le complexe C₂ se transforme par oxydation en complexe C₁. Cette transformation réversible est due à des réactions d'oxydation et de réduction liées à la présence ou l'absence de lumière et la présence ou non d'oxygène. Les réactions peuvent être suivies expérimentalement en raison des changements de couleur accompagnant le processus de diffusion du diethyléther, qui est un liquide incolore, dans une solution de DMF.

La figure 2 est une vue schématique qui illustre la structure moléculaire du complexe C₁. Les ellipsoïdes contiennent 50 % de la densité électronique. Les lignes en pointillé représentent les liaisons intramoléculaires de l'hydrogène. Ci-après, sont spécifiées certaines longueurs de liaisons (Å) et certains angles (°) : Fe-02, 1.973 Å (4) ; Fe-04, 1.977 Å (4) ; Fe-O5, 2.035 Å (4) ; Fe-N4, 2.145 Å (5) ; Fe-N2, 2.213 Å (5) ; Fe-Cl, 2.3318 Å (14) ; 02-Fe-O4, 159.84 °(17) ; O5-Fe-N4, 166.56 °(17).

La figure 3 est une vue schématique qui illustre la structure moléculaire du complexe C₂. L'ellipsoïde contient 50 % de la densité électronique. Les lignes en pintillé représentent les liaisons intramoléculaires de l'hydrogène.

Ci-après, sont spécifiées certaines longueurs de liaisons (Å) et certains angles (°) : Fe1-O2, 2.115 Å (1) ; Fe1-O4, 2.122 Å (1) ; Fe1-N4, 2.199 Å (1) ; Fel-N2, 2.229 Å (1), Fe1-Cl1 2.4396 Å (7), Fe1-Cl2 2.4613 Å (7) ; 02-Fe1-O4, 175.41 ° (4) ; 04-Fe1-N4, 74.55 ° (4).La présence ou non d'un atome d'hydrogène sur l'azote central permet de confirmer la charge (Fe²⁺) ou (Fe³⁺) des atomes de fer.

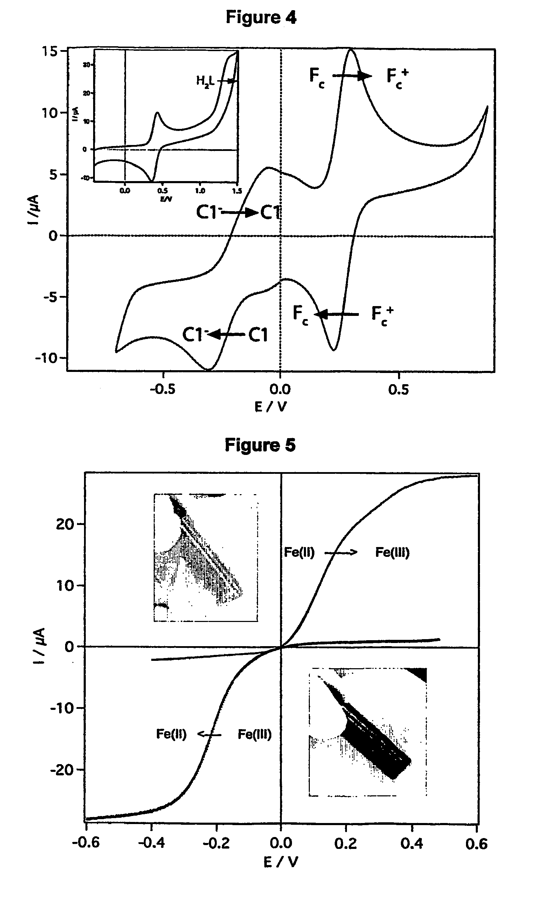

La figure 4 représente un cyclovoltammogramme du complexe C₁ (1 mM) dans la DMF avec une électrode de platine, un électrolyte support nBU4PF6 0,2 M et une vitesse de balayage de 100 mV.s⁻¹). Le cyclovoltammogramme du ligand H₂L est représenté en insert et dans les mêmes conditions expérimentales.

La figure 5 représente les courbes intensité/potentiel mesurées sur électrode quasi stationnaire en carbone vitreux pour le complexe C₁ et le complexe C₂ dans la solution DMF avec un électrolyte support nBU₄NPF_{6.} 0,2 M, une vitesse de balayage 2 mV.s⁻¹ et une vitesse de rotation de 1000 rpm.

Selon l'étude électrochimique qui est résumée sur les figures 4 et 5, le complexe C₁ a été étudié par voltampérométrie cyclique ainsi que par voltampérométrie pseudo stationnaire. Dans les deux cas, la présence de ferrocene dans le milieu montre une bonne validité des mesures électrochimiques. La signature électrochimique du complexe C₁ est en accord avec un système C₁/ C₁⁻ réversible tandis que le ligand H₂L ne montre que la vague d'oxydation de son cycle redox. On peut affirmer que le signal électrochimique du couple C₁/ C₁⁻ observé par voltampérométrie cyclique correspond au couple redox C₁/C₂.

Les complexes moléculaires C₁ et C₂, en plus de leur synthèse aisée et de leur stabilité chimique, absorbe la lumière dans le proche ultra-violet c'est-à-dire des rayons dont la longueur d'onde est située approximativement entre 300 et 350 nm. C'est le ligand de type hydrazide qui est responsable de cette absorption dans l'UV, en solution comme à l'état solide. L'originalité du système est le changement du degré d'oxydation qui est utilisable pour la circulation d'électrons. La solution de fer (Fe ³⁺) est stable à l'abri de la lumière, et la solution de fer +II est stable à l'abri de l'air. En effet, la solution jaune de fer (Fe ²⁺) s'oxyde très facilement à l'air. A titre expérimental, il suffit de faire passer de l'air durant un intervalle de temps relativement court, par exemple une minute, dans un récipient contenant une solution du complexe C₂ pour la transformer en solution du complexe C₁, bleu sombre. Placée pendant quelques heures en pleine lumière naturelle, la solution bleue sombre du complexe C₁ se réduit en solution jaune du complexe C₂. On notera que les solutions s'enrichissent en eau dans ces conditions en raison de la réduction de l'oxygène (O₂) en eau (H₂O).

En résumé, l'absorption de lumière des complexes moléculaires C₁ et C₂ s'accompagne d'un changement de degré d'oxydation ou de réduction du centre métallique, en l'occurrence le fer, le cuivre ou similaire, conduisant à de nouveaux complexes moléculaires stables en solution ainsi qu'à l'état solide. Ce phénomène est une réduction chimique induite par la lumière, accompagnée par une séparation spontanée d'espèces, le complexe réduit d'une part et l'espèce oxydée d'autre part.

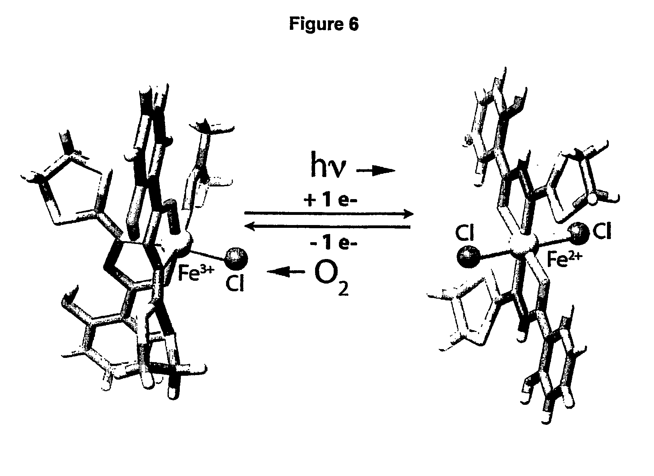

La figure 6 illustre le mécanisme du phénomène. La stabilité de la forme réduite est liée à une réorganisation moléculaire induisant un changement du potentiel apparent du système redox. En effet, lors de la réduction du Fe (Fe ³⁺) en Fe (Fe ²⁺), une espèce est nécessairement oxydée dans le milieu. Compte tenu du caractère chromophore du ligand, on estime a priori que ce dernier cède un électron au métal, mais les analyses du produit final, à savoir le complexe C₂ en solution et à l'état cristallin, montre clairement que les molécules de ligand ne sont pas dans un état oxydé. Le défaut électronique a donc été transféré dans le milieu sur les molécules de solvant puisque le centre métallique n'est pas réoxydé spontanément.

Cependant, cette situation particulière avec une partie oxydée transférée vers le solvant qui peut être du DMF, du THF, de l'éthanol ou de l'eau permet d'envisager de nouveaux types de cellules solaires à oxydo-réduction (redox) avec une technologie particulièrement simple. Le dispositif selon l'invention constitue un système photoréductible à séparation d'espèces spontanée.

### Possibilités d'application industrielle :

Le procédé et le dispositif de l'invention ouvrent une voie nouvelle dans l'élaboration de systèmes simples et bons marchés, du fait que l'élément chimique est le fer, pour la transformation de la lumière en électricité. A une époque où les sources d'énergie deviennent des enjeux majeurs, la mise au point de nouveaux systèmes physico-chimiques capables de transformer l'énergie lumineuse en énergie électrique est fondamentale. De plus, et compte-tenu de la situation environnementale, les nouvelles sources ou systèmes producteurs d'énergie doivent et devront répondre à des critères de reconversion et/ou de transformation sans nuisance pour la biosphère.

## Revendications

1. Procédé de production et de stockage d'énergie électrique utilisant des complexes d'un métal, **caractérisé en ce que** l'on utilise un complexe moléculaire de fer dérivant de l'acide benzoïque, ce complexe comportant au moins un ligand organique (L) de type benzoïque hydrazide, et l'on crée des réactions d'oxydoréduction dans ledit complexe moléculaire de fer en l'exposant à la lumière, à l'abri de l'air, et réciproquement à l'air, à l'abri de la lumière.

2. Procédé selon la revendication 1, **caractérisé en ce que** ledit ligand organique est choisi parmi la famille de ligands définis par la formule :

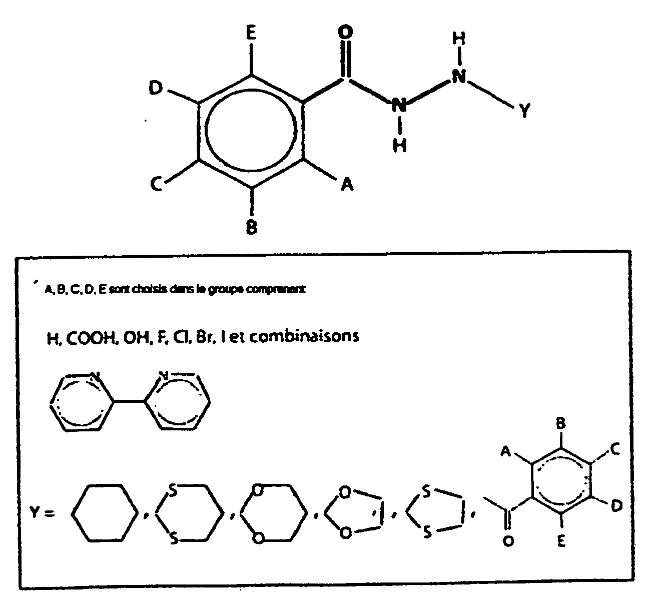

3. Procédé selon la revendication 1, **caractérisé en ce que** ledit complexe de fer est soit : le complexe de fer (Fe ³⁺) défini par la formule [Fe^{III}(HL)ₓCl, Solvant], soit le complexe de fer (Fe ²⁺) défini par la formule [Fe^{II}(H₂L)₂Cl₂].

4. Procédé selon la revendication 3, **caractérisé en ce que** l'on produit une réduction du fer (Fe ³⁺) dans ledit complexe [Fe^{III}(HL)ₓCl, Solvant] en fer (Fe ²⁺) dans ledit complexe [Fe^{II}(H₂L)₂Cl₂] en l'exposant à la lumière à l'abri de l'oxygène.

5. Procédé selon la revendication 3, **caractérisé en ce que** l'on produit une oxydation du fer (Fe ²⁺) dans ledit complexe [Fe^{II}(H₂L)₂Cl₂] en fer (Fe ³⁺) dans ledit complexe [Fe^{III}(HL)ₓCl, Solvant] en créant un contact chimique ou électrochimique avec un oxydant, à l'abri de la lumière.

6. Procédé selon la revendication 5, **caractérisé en ce que** ledit oxydant est choisi dans le groupe : O₂, I₂, Cu²⁺ Co³⁺,FeCl, H⁺, manganate et permanganate, ferrates.

7. Procédé selon l'une quelconque des revendications 3, 4 ou 5, **caractérisé en ce que** l'on choisit ledit solvant parmi les solvants suivants : le diméthylformamide (DMF), le tétrahydrofurane (THF), l'éthanol, l'eau.

8. Dispositif de production et de stockage d'énergie électrique, pour la mise en oeuvre du procédé selon l'une quelconque des revendications 1 à 7, **caractérisé en ce qu'**il comprend un complexe moléculaire de fer comportant au moins un ligand organique (L) de type acide benzoïque hydrazide.

9. Dispositif selon la revendication 8, **caractérisé en ce que** ledit ligand organique (L) est choisi parmi la famille de ligands définis par la formule ci-dessous :

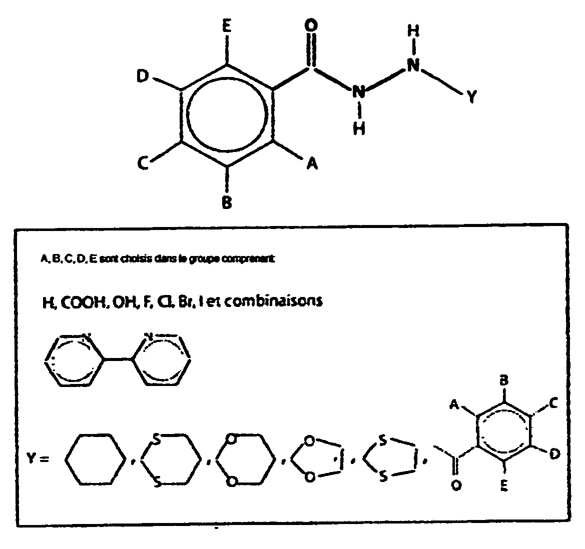

10. Dispositif selon la revendication 8, **caractérisé en ce que** ledit complexe de fer est soit : le complexe de fer (Fe ³⁺) défini par la formule [Fe^{III}(HL)ₓCl, Solvant], soit le complexe de fer (Fe ²⁺) défini par la formule [Fe^{II}(H₂L)₂Cl₂].

11. Dispositif selon la revendication 8, **caractérisé en ce qu'**il comporte des moyens pour produire une réduction du fer (Fe ³⁺) dans ledit complexe [Fe^{III}(HL)ₓCl, Solvant] en fer (Fe ²⁺) dans ledit complexe [Fe^{II}(H₂L)₂Cl₂] ces moyens impliquant une exposition à la lumière à l'abri d'un oxydant, dudit complexe de fer (Fe ³⁺).

12. Dispositif selon la revendication 8, **caractérisé en ce qu'**il comporte des moyens pour produire une oxydation du fer (Fe ²⁺) dans ledit complexe [Fe^{II}(H₂L)₂Cl₂] en fer (Fe ³⁺) dans ledit complexe [Fe^{III}(HL)₂Cl, Solvant] ces moyens impliquant une action d'un oxydant adapté, à l'abri de la lumière sur ledit complexe de fer (Fe ²⁺).

## Claims

1. Method and device for producing and storing electrical energy using complexes of a metal, **characterised in that** one uses a molecular iron complex derived from benzoic acid, this complex comprising at least one organic ligand (L) of the benzoic hydrazide type, and one creates oxidoreduction reactions in said molecular iron complex by exposing it to light, under absence of air, and vice-versa by exposing it to air, under absence of light.

2. Method according to claim 1, **characterised in that** said organic ligand (L) is chosen among the ligands family defined by the formula:

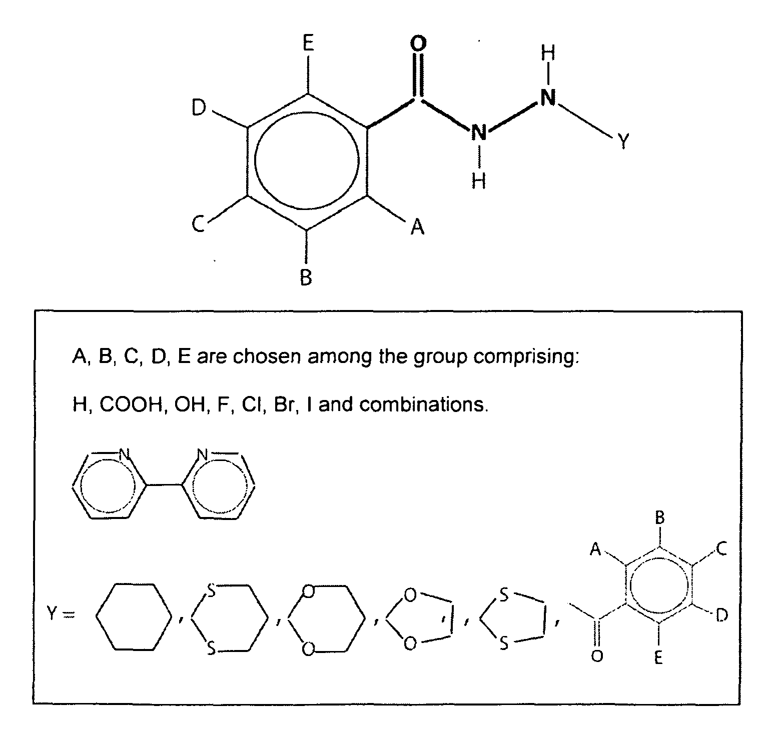

3. Method according to claim 1, **characterised in that** said iron complex is either: the iron complex (Fe 3+) defined by the formula [FeIII(HL)xCl, Solvent], or the iron complex (Fe 2+) defined by the formula [FeII(H2L)2Cl2].

4. Method according to claim 3, **characterised in that** one produces a reduction of the (Fe 3+) iron in said [FeIII(HL)xCl, Solvent] complex into (Fe 2+) iron in said [FeII(H2L)2Cl2] complex by exposing it to light in the absence of oxygen.

5. Method according to claim 3, **characterised in that** one produces an oxidation of the (Fe 2+) iron in said [FeII(H2L)2Cl2] complex into (Fe 3+) iron in said [FeIII(HL)xCl, Solvent] complex by creating a chemical or electrochemical contact with an oxidant, in the absence of light.

6. Method according to claim 5, **characterised in that** said oxidant is chosen in the group: O2, I2, Cu2+, Co3+, FeCl3, H+, manganate and permanganate, ferrates.

7. Method according to any of claims 3, 4 or 5, **characterised in that** one chooses said solvent among the following solvents: dimethylformamide (DMF), tetrahydrofuran (THF), ethanol, water.

8. Device for producing and storing electrical energy, for the implementation of the method according to any of claims 1 to 7, **characterised in that** it comprises a molecular iron complex comprising at least one organic ligand (L) of the benzoic hydrazide acid type.

9. Device according to claim 8, **characterised in that** said organic ligand (L) is chosen among the ligands family defined by the following formula:

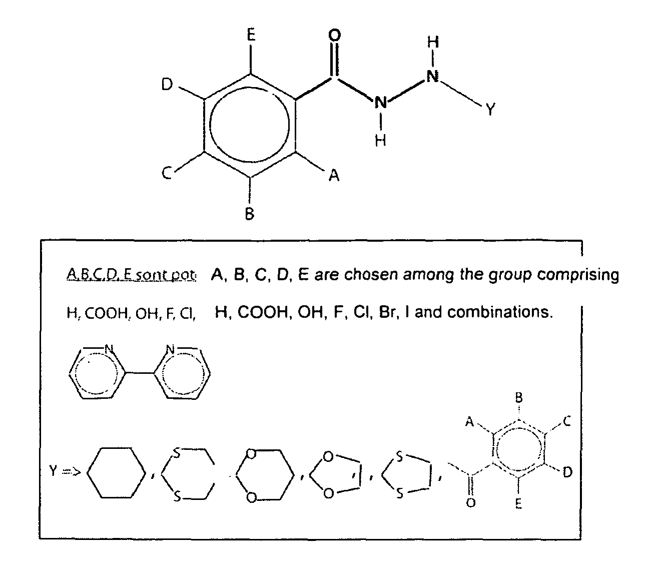

10. Device according to claim 8, **characterised in that** said iron complex is either: the (Fe 3+) iron complex defined by the formula [FeIII(HL)xCl, Solvent], or the (Fe 2+) iron complex defined by the formula [FeII(H2L)2Cl2].

11. Device according to claim 8, **characterised in that** it comprises means for producing a reduction of the (Fe 3+) iron in said [FeIII(HL)xCl, Solvent] complex into (Fe 2+) iron in said [FeII(H2L)2Cl2] complex, these means involving an exposition to light in the absence of an oxidant of said iron complex (Fe 3+).

12. Device according to claim 8, **characterised in that** it comprises means for producing an oxidation of the (Fe 2+) iron in said [FeII(H2L)2Cl2] complex into (Fe 3+) iron in said [FeIII(HL)2Cl, Solvent] complex, these means involving an action of a suitable oxidant in the absence of light on said iron complex (Fe 2+).

## Patentansprüche

1. Verfahren zur Produktion und Speicherung von elektrischer Energie unter Verwendung eines Metall-Komplexes, **dadurch gekennzeichnet, dass** man einen von Benzoesäure abgeleiteten Eisenmolekülkomplex verwendet, wobei dieser Komplex mindestens einen organischen Liganden (L) des Typs Benzoesäure-Hydrazid beträgt, und man Redoxreaktionen in dem besagten Eisenmolekülkomplex dadurch hervorruft, dass man diesen unter Ausschluss von Luft dem Licht und umgekehrt unter Ausschluss von Licht der Luft aussetzt.

2. Verfahren nach Anspruch 1, **dadurch gekennzeichnet, dass** der besagte organische Ligand (L) in der mit folgender Formel definierten Liganden-Familie gewählt wird:

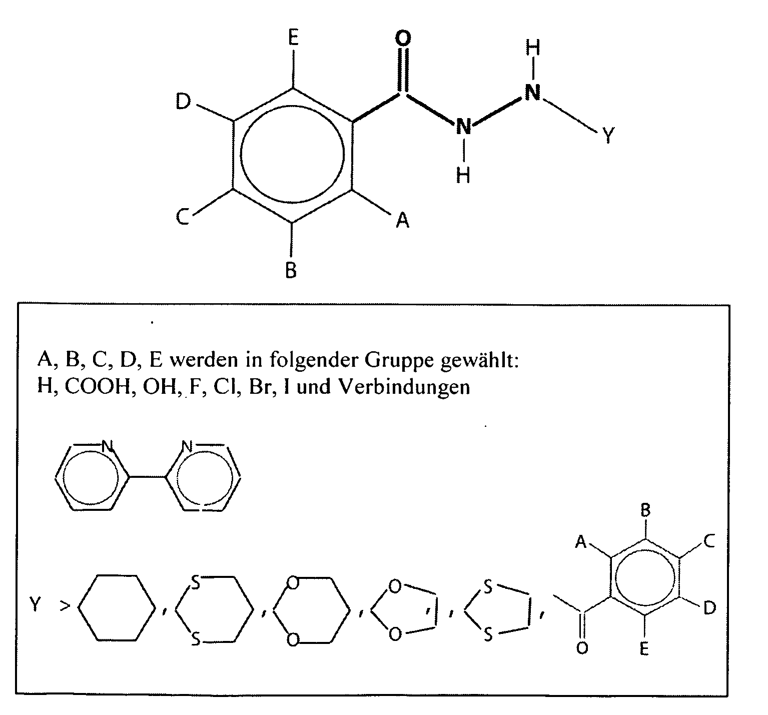

3. Verfahren nach Anspruch 1, **dadurch gekennzeichnet, dass** der besagte Eisenkomplex entweder der durch die Formel [Fe^{III}(HL)ₓCl, Solvent] definierte Eisenkomplex (Fe ³⁺) oder der durch die Formel [Fe^{II}(H₂L)₂Cl2] definierte Eisenkomplex (Fe ²⁺) ist.

4. Verfahren nach Anspruch 3, **dadurch gekennzeichnet, dass** man durch Aussetzen an Licht unter Ausschluss von Sauerstoff eine Reduktion des (Fe ³⁺)-Eisens in dem besagten Komplex [Fe^{III}(HL)ₓCl, Solvent] in (Fe ²⁺)-Eisen in dem besagten Komplex [Fe^{II}(H₂L)₂Cl₂] hervorruft.

5. Verfahren nach Anspruch 3, **dadurch gekennzeichnet, dass** man durch Erstellung eines chemischen oder elektrochemischen Kontakts mit einem Oxidationsmittel unter Ausschluss von Licht eine Oxidation des (Fe ²⁺)-Eisens in dem besagten Komplex [Fe^{II}(H₂L)₂Cl2] in (Fe ³⁺)-Eisen in dem besagten Komplex [Fe^{III}(HL)ₓCl, Solvent] hervorruft.

6. Verfahren nach Anspruch 5, **dadurch gekennzeichnet, dass** das besagte Oxidationsmittel in der Gruppe: O₂, I₂, Cu²⁺, Co³⁺, FeCl₃, H⁺, Manganat und Permanganat, Ferrate gewählt wird.

7. Verfahren nach irgendwelchem der Ansprüche 3, 4 oder 5, **dadurch gekennzeichnet, dass** man den besagten Solventen unter folgenden Solventen wählt: Dimethylformamid (DMF), Tetrahydrofuran (THF), Ethanol, Wasser.

8. Vorrichtung zur Produktion und Speicherung von elektrischer Energie für die Umsetzung des Verfahrens nach irgendwelchem der Ansprüche 1 bis 7, **dadurch gekennzeichnet, dass** sie einen Eisenmolekülkomplex beträgt, der mindestens einen organischen Liganden (L) des Typs Benzoesäure-Hydrazid aufweist.

9. Vorrichtung nach Anspruch 8, **dadurch gekennzeichnet, dass** der besagte organische Ligand (L) in der mit folgender Formel definierten Liganden-Familie gewählt wird:

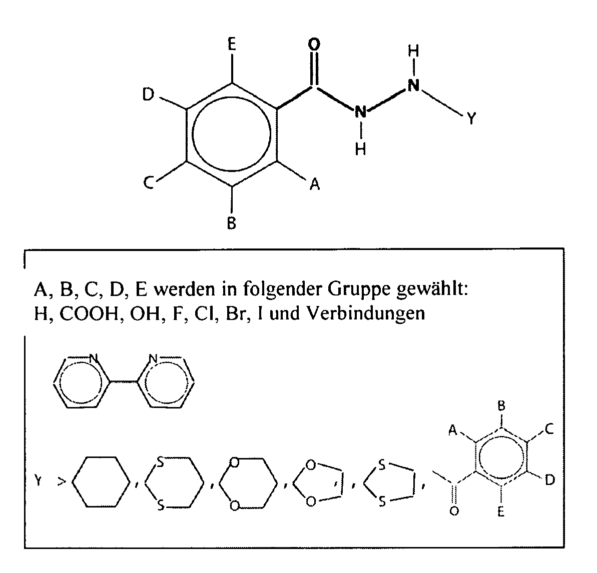

10. Vorrichtung nach Anspruch 8, **dadurch gekennzeichnet, dass** der Eisenkomplex entweder der durch die Formel [Fe^{III}(HL)ₓCl, Solvent] definierte Eisenkomplex (Fe ³⁺) oder der durch die Formel [Fe^{II}(H₂L)₂Cl_{2]} definierte Eisenkomplex (Fe ²⁺) ist.

11. Vorrichtung nach Anspruch 8, **dadurch gekennzeichnet, dass** sie Mittel zur Erzeugung einer Reduktion des (Fe ³⁺)-Eisens in dem besagten Komplex [Fe^{III}(HL)ₓCl, Solvent] in (Fe ²⁺)-Eisen in dem besagten Komplex [Fe^{II}(H₂L)₂Cl₂] beträgt, wobei diese Mittel ein Aussetzen an Licht des besagten Eisenkomplexes(Fe ³⁺) in Abwesenheit von Oxidationsmitteln beinhalten.

12. Vorrichtung nach Anspruch 8, **dadurch gekennzeichnet, dass** sie Mittel zur Erzeugung einer Oxidation des (Fe ²⁺)-Eisens in dem besagten Komplex [Fe^{III}(H₂L)₂Cl₂] in (Fe ³⁺)-Eisen in dem besagten Komplex [Fe^{III}HL)₂Cl, Solvent] beträgt, wobei diese Mittel die Einwirkung eines geeigneten Oxidationsmittels in Abwesenheit von Licht auf den besagten Eisenkomplex (Fe ²⁺) beinhalten.
